# EUROPEAN PATENT APPLICATION

(11) **EP 4 608 083 A1**
(43) Date of publication of application: **27.08.2025**
(21) Application number: 23880172.4
(22) Date of filing: 17.10.2023
(51) Int. Cl.: H05K 9/00, H05K 5/00, H01R 13/652

(54) **ELECTRONIC DEVICE**

(30) Priority: 18.10.2022 KR 20220134431
(71) Applicant: LG INNOTEK CO. LTD, Gangseo-gu Seoul 07796 (KR)
(72) Inventor: JEONG, Jae In, Seoul 07796 (KR)
(74) Representative: Plasseraud IP
(86) International application number: PCT/KR2023/016034
(87) International publication number: WO 2024/085595

(57) **Abstract**

This electronic device comprises: a housing having a receiving part formed therein and comprising a polymer resin; a printed circuit board disposed in the receiving part; a connector connected to the printed circuit board; and a shielding member disposed in the receiving part and covering at least a portion of the printed circuit board, wherein the shielding member includes a first region and a second region disposed to have a level difference in the vertical direction with respect to the first region, and the connector includes a ground pin that is in contact with the second region.

## Description

### TECHNICAL FIELD

This embodiment relates to an electronic device.

### BACKGROUND ART

Electronic devices of a vehicle typically include engine electrical devices (starting devices, ignition devices, charging devices, etc.) and lighting devices, but recently, as the vehicle has become more electronically controlled, most systems including chassis electrical devices are becoming more electronic.

Various electronic devices installed in vehicles such as lamps, audios, heaters, and air conditioners are supplied with power from batteries when the vehicles are stopped and from generators when the vehicles are running. In this case, power generation capacity of a 14 V power system is used as a normal power voltage.

Recently, with the development of the information technology industry, various new technologies (motorized power steering, Internet, etc.), which are aimed to increase convenience of vehicles are being incorporated into the vehicles, and it is expected that development of new technologies that are capable of utilizing the most of the current vehicle systems will continue in the future.

An outer appearance of an electronic device is defined by a housing. A plurality of electronic components for driving are disposed inside the housing. The plurality of electronic components generate heat when driven.

### DISCLOSURE OF THE INVENTION

### TECHNICAL PROBLEM

This embodiment provides an electronic device capable of improving heat dissipation efficiency while reducing a weight thereof.

### TECHNICAL SOLUTION

An electronic device according to this embodiment includes: a housing provided with a receiving part therein and including a polymer resin; a printed circuit board disposed in the receiving part; a connector connected to the printed circuit board; and a shielding member disposed in the receiving part and configured to at least a portion of the printed circuit board, wherein the shielding member includes a first region and a second region disposed to have a height difference in a vertical direction with respect to the first region, and the connector includes a ground pin that is in contact with the second region.

The shielding member may be made of a metal material and be integrated with the housing by insert injection.

At least a portion of the second region may be disposed to overlap the connector and the printed circuit board in the vertical direction.

The receiving part may include a support protruding from a bottom surface, and the shielding member may include a third region disposed to have a height difference in the vertical direction with respect to the first region, wherein the third region may be disposed on the support.

The printed circuit board may be disposed on the support, and the printed circuit board, the third region, and the support may be screw-coupled to each other.

The electronic device may further include a ground member disposed in the housing and having one end disposed inside the support so as to be screw-coupled to the printed circuit board, the third region, and the support.

The housing may include a shielding coupling part protruding from an outer surface and having a first screw hole, and the ground member may have the other end in which a second screw hole facing the first screw hole is defined.

The ground member may be integrated with the housing by insert injection.

The printed circuit board, the third region, the support, and the ground member may be disposed to overlap each other in the vertical direction.

The shielding member may include a side surface portion extending from an edge of the first region, wherein the side surface portion may be disposed to face an inner surface of the housing.

### ADVANTAGEOUS EFFECTS

In this embodiment, the shielding member and the ground member, each of which is made of the metal, may be integrated with the housing made of the plastic material by the insert injection to prevent the electrical noise between the space inside the housing and the external region from occurring and simply implement the ground structure between the housing, the connector, and the printed circuit board.

### BRIEF DESCRIPTION OF THE DRAWINGS

FIG. 1 is a perspective view illustrating an outer appearance of an electronic device according to an embodiment of the present invention.
FIG. 2 is an exploded perspective view of the electronic device according to an embodiment of the present invention.
FIG. 3 is an exploded perspective view of a housing and a shielding member according to an embodiment of the present invention.
FIG. 4 is a perspective view illustrating a coupling structure of the housing and the shielding member according to an embodiment of the present invention.
FIG. 5 is a view illustrating a coupling structure of a connector, the shielding member, a printed circuit board, and the housing according to an embodiment of the present invention.
FIG. 6 is a view illustrating a coupling structure of a ground member and the shielding member according to an embodiment of the present invention.

### MODE FOR CARRYING OUT THE INVENTION

Hereinafter, preferred embodiments of the present invention will be described in detail with reference to the accompanying drawings.

However, the technical idea of the present invention is not limited to some of the embodiments described, but may be implemented in various different forms, and one or more of the components in embodiments may be selectively combined, substituted for use even within the scope of the technical idea of the present invention.

In addition, terms (including technical and scientific terms) used in the embodiments of the present invention may be interpreted as having a meaning that may be generally understood by a person of ordinary skill in the technical field to which the present invention belongs, unless explicitly and specifically defined and described, and the terms that are commonly used, such as terms defined in a dictionary, may be interpreted in consideration of the contextual meaning of the relevant technology.

In addition, the terms used in the embodiments of the present invention are for the purpose of describing the embodiments and are not intended to limit the present invention. In this specification, the singular may also include the plural unless specifically stated otherwise in the phrase, and when it is described as "A and (or at least one) of B, C", it may include one or more of all combinations that may be combined with A, B, C.

In the description of the elements of the present invention, the terms first, second, A, B, (a), and (b) may be used.

These terms are only used to distinguish the component from other components, and the essence, sequence, or order of the corresponding component is not limited by the term.

In addition, when a component is described as being 'connected', 'coupled', or 'linked' to another component, it may include not only cases where the component is 'connected', 'coupled', or 'linked' directly to the other component, but also cases in which the component is 'connected', 'coupled', or 'linked' by another component between the component and the other component.

In addition, when described as being formed or arranged "above (upper)" or "below (lower)" each component, "above (upper)" or "below (lower)" includes not only the case where the two components are in direct contact with each other, but also the case in which one or more other components are formed or arranged between the two components. In addition, when expressed as "above (upper)" or "below (lower) ", it may include the meaning of not only the upward direction but also the downward direction based on one component.

An electronic device according to this embodiment is provided in a vehicle and may include a converter, a pump, and an electronic control unit (ECU). However, this is only an example, and the electronic device may include various devices that include at least one electronic component disposed within a housing and may be electrically connected to an external terminal through a connector.

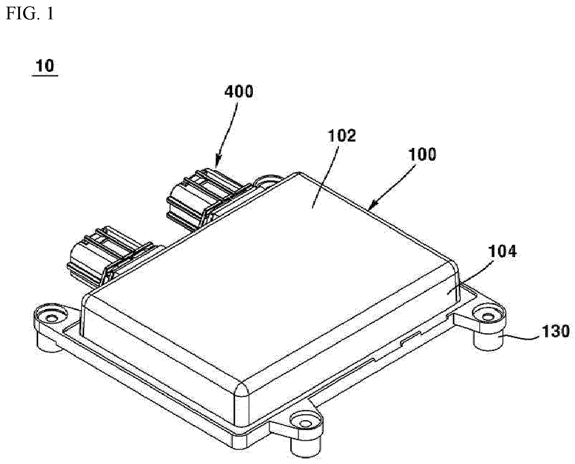

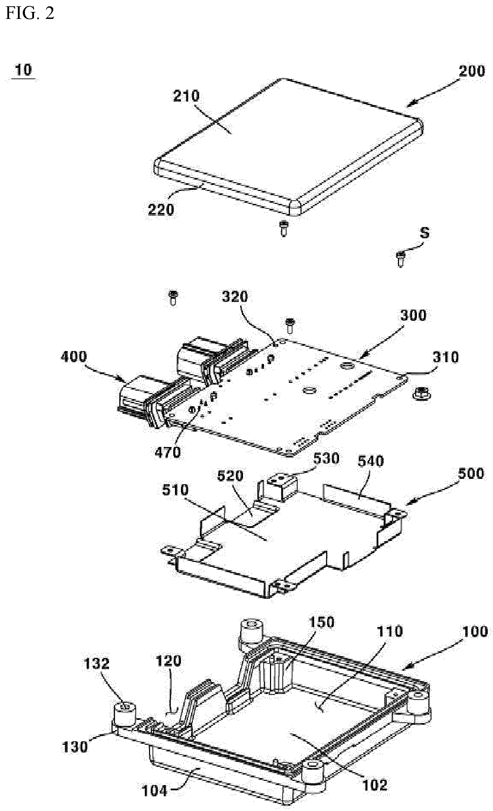

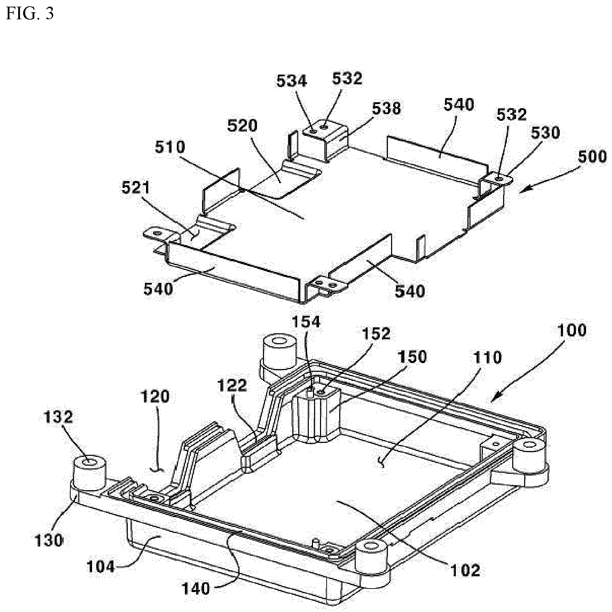

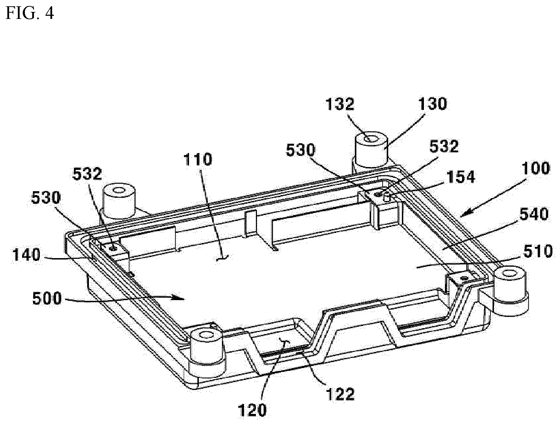

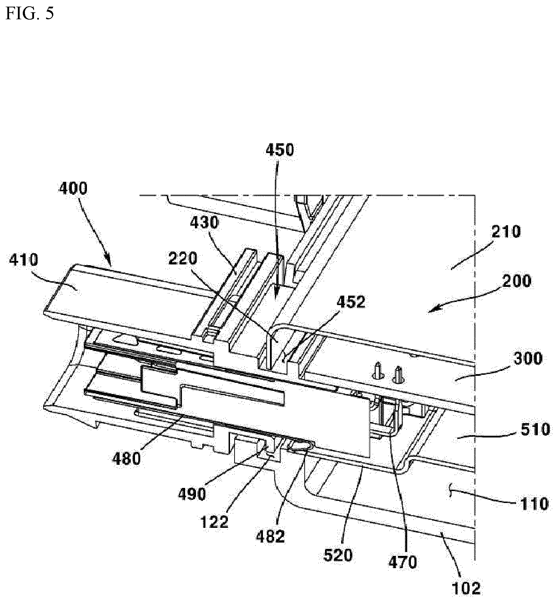

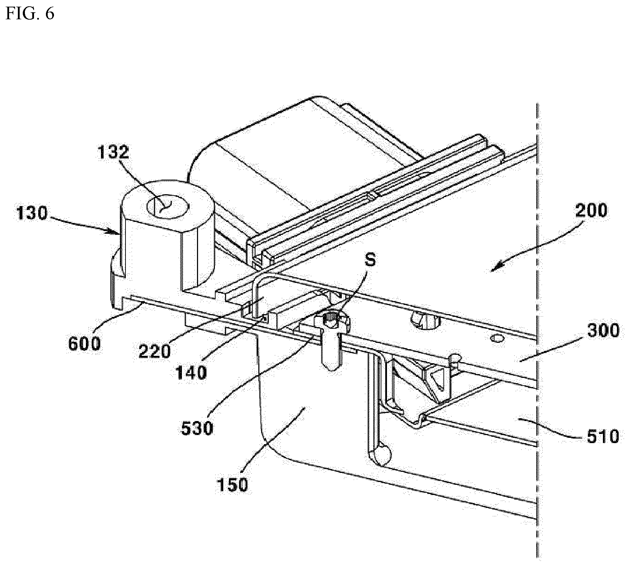

FIG. 1 is a perspective view illustrating an outer appearance of an electronic device according to an embodiment of the present invention, FIG. 2 is an exploded perspective view of the electronic device according to an embodiment of the present invention, FIG. 3 is an exploded perspective view of a housing and a shielding member according to an embodiment of the present invention, FIG. 4 is a perspective view illustrating a coupling structure of the housing and the shielding member according to an embodiment of the present invention, FIG. 5 is a view illustrating a coupling structure of a connector, the shielding member, a printed circuit board, and the housing according to an embodiment of the present invention, and FIG. 6 is a view illustrating a coupling structure of a ground member and the shielding member according to an embodiment of the present invention.

Referring to FIGS. 1 to 6, an electronic device 10 according to an embodiment of the present invention may include a housing 100, a cover 200, a printed circuit board 300, a connector 400, a shielding member 500, and a ground member 600.

The housing 100 may define an outer appearance of the electronic device 10. The housing 100 may have a rectangular cross-sectional shape. The housing 100 may have a box shape. A receiving part 110 may be provided inside the housing 100 to accommodate components for driving the electronic device 10, which include the printed circuit board 300 and the shielding member 500. The receiving part 110 may be opened upward. The cover 200 may be coupled to a top surface of the housing 100 to cover a top surface of the receiving part 110.

The housing 100 may include a lower plate 102 and a side plate 104 that extends upward from an edge of the lower plate 102 to extend. The lower plate 102 may define a bottom surface of the electronic device 10. The side plate 104 may define a side surface of the electronic device 10. At least one hole 120 may be defined in the side plate 104. When the housing 100 is viewed from above, the hole 120 may have a groove shape that is stepped downward from the other region. The connector 400 may be disposed in the hole 120. The holes 120 may be provided in plurality and disposed adjacent to each other on one side surface of the housing 100.

A support 150 may be disposed on the receiving part 110 within the housing 100. The support 150 may have a shape that protrudes upward from a top surface of the lower plate 102. A top surface of the support 150 may be disposed lower than a top surface of the side plate 104. The top surface of the support 150 may support a bottom surface of the printed circuit board 300. The top surface of the support 150 may be in contact with the bottom surface of the printed circuit board 300. Due to the support 150, the bottom surface of the printed circuit board 300 may be spaced apart from the top surface of the lower plate 102 in a vertical direction.

The support 150 may be provided in plurality, which are respectively disposed at four corner regions of the receiving part 110 within the housing 100.

A protrusion 154 and a first coupling hole 152 may be provided on/in the top surface of the support 150. The protrusion 154 may have a shape that protrudes upward from the top surface of the support 150. The first coupling hole 152 may have a shape that is recessed downward from the top surface of the support 150 compared to other regions. The protrusion 154 may be coupled to a second coupling hole 534 of the shielding member 500, which will be described later. The first coupling hole 152 may be disposed to face a third coupling hole 532 of the shielding member 500, which will be described later, in the vertical direction.

A first coupling groove 140 having a shape that is recessed more than other regions may be defined in the top surface of the housing 100. The first coupling groove 140 may be defined in a top surface of the side plate 104 of the housing 100. The side plate 220 of the cover 200 may be coupled to the first coupling groove 140. The first coupling groove 112 may be defined along a circumference of the top surface of the housing 100. The side plate 104 of the housing 100 may be referred to as a first side plate, and the side plate 220 of the cover 200 may be referred to as a second side plate.

A second coupling groove 122 having a shape that is more recessed than other regions may be defined in an inner surface of the hole 120 of the housing 100. The second coupling groove 122 may be defined in an inner circumferential surface of the hole 120. The second coupling groove 122 may be connected to the first coupling groove 140. Each of the first coupling groove 140 and the second coupling groove 122 may have a rectangular cross-sectional shape.

A vehicle body coupling part 130 may be disposed on an outer surface of the housing 100. The vehicle body coupling part 130 may have a shape that protrudes further outward than other regions from the outer surface of the housing 100. The vehicle body coupling part 130 may be provided in plurality, which are respectively disposed in corner regions of the housing 100. A first screw hole 132 into which a screw (not shown) is coupled may be defined in a top surface of the vehicle body coupling part 130. Due to the vehicle body coupling part 130, the electronic device 10 may be coupled to a vehicle body defining a frame of the vehicle, such as a chassis. In this case, the screw may be screw-coupled to each of the vehicle body and the first screw hole 132 of the vehicle body coupling part 130.

A material of the housing 100 may be a polymer resin. The material of the housing may be plastic. Thus, the electronic device 10 may be lightweight compared to a device made of metal.

The cover 200 may be disposed on an upper portion of the housing 100. The cover 200 may be coupled to cover the top surface of the receiving part 110. The cover 200 may include an upper plate 210 and a side plate 220 extending downward from an edge of the upper plate 210. The upper plate 210 may define a top surface of the electronic device 10, and the side plate 220 may define a side surface of the electronic device 10 together with the side plate 104 of the housing 100. A lower end of the side plate 220 may be coupled to the first coupling groove 140. A portion of the lower end of the side plate 220 may be coupled to a third coupling groove 452 (see FIG. 5) of a connector module 400, which will be described later.

The printed circuit board 300 may be disposed in the receiving part 110 within the housing 100. The printed circuit board 300 may be provided in a plate shape, and at least one or more electronic components for driving the electronic device 10 may be disposed on at least one surface of the top and bottom surfaces. The printed circuit board 300 may be coupled to a pin 470 (see FIG. 5) of the connector 200, which will be described later. The printed circuit board 300 may include a pinhole, to which the pin 470 is coupled, and the pin 470 may be coupled to the pinhole.

The bottom surface of the printed circuit board 300 may be supported by the top surface of the support 150. The top surface of the support 150 may be in contact with the bottom surface of the printed circuit board 300. The printed circuit board 300 may include a fourth coupling hole 310 facing the first coupling hole 152 defined in the support 150, and the screw may be screw-coupled within the first coupling hole 152 of the support 150 by passing through the fourth coupling hole 310 of the printed circuit board 300 and the third coupling hole 532 of the shielding member 500. The printed circuit board 300 may include a fifth coupling hole 320 to which the protrusion 154 is coupled. The fifth coupling hole 320 may have a shape that passes from the top surface to the bottom surface of the printed circuit board 300. The protrusion 154 may be coupled to the second coupling hole 534 of the shielding member 500 and the fifth coupling hole 320 of the printed circuit board 300.

A portion of the bottom surface of the printed circuit board 300 may be supported by the connector 400. A portion of the bottom surface of the printed circuit board 300 may be in contact with the top surface of the connector 400.

The connector 400 may be disposed to pass through the side surface of the housing 100. The connector 400 may be disposed to pass through the hole 120. The connector 400 may be coupled to the hole 120.

The connector 400 may be coupled to an external terminal, and thus, power may be supplied to the electronic device 10, or a control signal related to the driving of the electronic device 10 may be transmitted and received to/from an external component.

The connector 400 may include one end disposed in the receiving part 110 within the housing 100 and the other end disposed to be opposite the one end and on the outside of the housing 100.

The connector 400 may have an outer appearance defined by a connector housing. A material of the connector housing may be plastic. A pin 470 may be disposed on one end of the connector housing disposed in the receiving part 110 within the housing 100. The pin 470 protruding from one end of the connector housing may have a region that is bent at least once so as to be coupled to the printed circuit board 300.

In detail, the connector housing defining an outer appearance of the connector 400 may include a first region 410, a second region 450, and a guide 430.

The first region 410 may be disposed outside the housing 100. An external terminal may be coupled to the first region 410. Thus, the first region 410 may be named a connector withdrawal part. The first region 410 may have a shape that protrudes outward from the housing 100.

The second region 450 may be disposed within the housing 100. At least a portion of the second region 450 may be coupled to the hole 120. The pin 470 may be disposed to protrude from an end of the second region 450. The pin 470 may be disposed along a space within the first region 410, the guide 430, and the second region 450 and may have one end coupled to the external terminal and the other end coupled to the printed circuit board 300. Thus, when the external terminal of the connector 400 is coupled through the pin 470, the electronic device 10 and the external terminal may be electrically connected to each other.

A rib having a shape that protrudes upward further than other regions may be disposed on the top surface of the second region 450. The rib may be disposed to pass through the printed circuit board 300. The printed circuit board 300 may have a hole defined to allow the rib to be coupled thereto.

A third coupling groove 452 that is recessed more than other regions may be defined in the top surface of the second region 450. The third coupling groove 452 may be disposed to overlap the side plate of the housing 100. The third coupling groove 452 may be connected to the first coupling groove 140. The third coupling groove 452 may be disposed to correspond to a formation region of the hole 120. Thus, when the cover 200 is coupled to the housing 100, a portion of the lower end of the cover 200 may be coupled to the first coupling groove 140, and a remaining portion may be coupled to the third coupling groove 452.

A protrusion 490 that protrudes downward further than other regions may be disposed on a bottom surface of the second region 450. The protrusion 490 may be coupled to the second coupling groove 122. A cross-sectional shape of the protrusion 290 may correspond to a cross-sectional shape of the second coupling groove 122. The protrusion 490 may be coupled to an inner surface of the hole 120.

The guide 430 may be disposed between the first region 410 and the second region 450. The guide 430 may be provided to have a larger cross-sectional area than that of each of the first region 410 and the second region 450. The guide 430 may be coupled to the side surface of the housing 100. An inner surface of the guide 430 may be in contact with the outer surface of the housing 400. As illustrated in FIG. 5, the side surface of the housing 100 that is in contact with the guide 430 may have a shape that protrudes outward more than other regions.

The connector 400 may include a ground pin 480. The ground pin 480 may be disposed inside the connector housing. One end of the ground pin 480 may be disposed to protrude downward from a bottom surface of the second region 450. A hole through which one end of the ground pin 480 passes may be defined on the bottom surface of the second region 450. One end of the ground pin 480 may have a region that is bent at least once. A contact part 482 that is in contact with the shielding member 500, which will be described later, may be defined in one end of the ground pin 480. The contact part 482 may have a cross-section in an approximately "U" shape. The ground pins 480 may be provided in plurality, which are disposed spaced apart from each other. The ground pin 480 may have a ground power source. The other end of the ground pin 480 may be disposed within the first region 410. The other end of the ground pin 480 may be connected to the external terminal.

The electronic device 10 may include the shielding member 500. The shielding member 500 may be called a shield plate. The shielding member 500 may be disposed in the receiving part 110 within the housing 100. The shielding member 500 may be made of a metal material. The shielding member 500 may be integrated with the housing 100 by insert injection. The shielding member 500 may be disposed in the receiving part 110 within the housing 100 to prevent electrical noise with the external area from occurring. The shielding member 500 may be connected to at least one of the printed circuit board 300, the connector 400, or the vehicle body to provide the ground power source.

In detail, the shielding member 500 may include a first region 510, a second region 520, and a third region 530. The first region 510, the second region 520, and the third region 530 may be provided as one body. The first region 510, the second region 520, and the third region 530 may be disposed to have height differences in the vertical direction.

The first region 510 may be provided in a plate shape. The first region 510 may be disposed on the lower plate 102 of the housing 100. A bottom surface of the first region 510 may be spaced a predetermined distance from the top surface of the lower plate 102. The first region 510 may be disposed parallel to the lower plate 102.

A top surface of the second region 520 may be disposed to be stepped downward from the top surface of the first region 510. When the formation region of the second region 520 is viewed from above, the second region 520 may have a groove shape in which a portion of the first region 510 is recessed downward. The second region 520 may be disposed to overlap the connector 400 in the vertical direction. The second region 520 may be disposed adjacent to the hole 120. The second region 520 may be disposed to overlap a coupling region of the pin 470 and the pinhole in the vertical direction.

The second region 520 may be in contact with the ground pin 480 of the connector 400. The second region 520 may be in contact with the housing 100. The second region 520 may be in contact with the contact part 482 disposed on an end of the ground pin 480. The contact part 482 may be in contact with a top surface of the second region 520. Since the contact part 482 and the second region 520 are in contact with each other, the shielding member 500 may be grounded. Since the contact part 482 and the second region 520 are in contact with each other, the shielding member 500 may prevent electric shock accidents due to leakage current in the region, in which a plurality of terminals are electrically connected to each other, from occurring, and also, a reference potential of 0 may be set.

A top surface of the third region 530 may be disposed to be stepped upward from the top surface of the first region 510. The third region 530 may be disposed on the support 150. A bottom surface of the third region 530 may be in contact with the top surface of the support 150. The shielding member 500 may include a connecting part 538 connecting the first region 510 to the third region 530. The connecting part 538 may have a shape that protrudes upward from the top surface of the first region 510. The connecting part 538 may be disposed to be perpendicular to the first region 510 and the third region 530.

The third region 530 may be coupled to the printed circuit board 300 and the housing 100. The third region 530 may include a third coupling hole 532 disposed to face the first coupling hole 152 of the housing 100 and the fourth coupling hole 310 of the printed circuit board 300, and a second coupling hole 534 disposed so that the protrusion 154 of the housing 100 passes therethrough. Each of the second coupling hole 534 and the third coupling hole 532 may have a shape that passes through the bottom surface from the top surface of the third region 530. The second coupling hole 534 and the third coupling hole 532 may be disposed adjacent to each other.

The third region 530 may overlap the housing 100, the printed circuit board 300, and the ground member 600 in the vertical direction. The third region 530 may include a hole that overlaps the housing 100, the printed circuit board 300, and the ground member 600 in the vertical direction. The third region 530 may be screw-coupled to the housing 100, the printed circuit board 300, and the ground member 600.

The shielding member 500 may extend upward from an edge of the first region 510 and include a side surface portion 540 defining the side surface of the shielding member 500. The side surface portion 540 may be disposed inside the side plate 104 of the housing 100. An outer surface of the side surface portion 540 may be in contact with an inner surface of the side plate 104. The side surface portion 540 may be disposed to perpendicular to the first region 510. The side surface portion 540 may be provided in plurality, which are disposed spaced apart from each other along an edge of the first region 510.

The shielding member 500 may be coated inside the housing 100.

The ground member 600 may be disposed inside the housing 100. The ground member 600 may be called an ESD plate.

The ground member 600 may be made of a metal material and may be integrated with the housing 100 by insert injection. The ground member 500 may be disposed between the inner and outer surfaces of the housing 100. The ground member 600 may have one end disposed within the support 150 and the other end disposed within the vehicle body coupling part 130. A sixth coupling hole may be defined in one end of the ground member 600 to face the first coupling hole 152 of the housing 100, the fourth coupling hole 310 of the printed circuit board 300, and the third coupling hole 532 of the shielding member 500. Thus, as illustrated in FIG. 6, the screw S may be disposed to pass through the first coupling hole 152, the fourth coupling hole 310, the third coupling hole 532, and the sixth coupling hole. The screw S may be coupled to the first coupling hole 152, the fourth coupling hole 310, the third coupling hole 532, and the sixth coupling hole.

The screw S may be called a screw or a connecting member.

A ground pattern may be disposed on the formation region of the fourth coupling hole 310 on the surface of the printed circuit board 300.

A second screw hole may be defined in the other end of the ground member 600 to face the first screw hole 132 of the housing 100. Thus, when the screw is coupled to the first screw hole 132 and the second screw hole, the ground member 600 may be electrically connected to the vehicle body.

According to the structure described above, the shielding member and the ground member, each of which is made of the metal, may be integrated with the housing made of the plastic material by the insert injection to prevent the electrical noise between the space inside the housing and the external region from occurring and simply implement the ground structure between the housing, the connector, and the printed circuit board.

All components may be coupled to one another to form a single body or to operate as a single body, but the present disclosure is not limited thereto. That is, one or more components are selectively coupled and operated within the scope of the present disclosure. In addition, the terms "include," "comprise," or "have," etc., as described above, unless otherwise specifically stated, imply that the corresponding component may be included, and therefore should be interpreted as including other components rather than excluding other components. Unless terms used in the present disclosure are defined differently, the terms may be construed as meaning known to those skilled in the art. Terms such as terms that are generally used and have been in dictionaries should be construed as having meanings matched with contextual meanings in the art. In this description, unless defined clearly, terms are not ideally, excessively construed as formal meanings.

The above-disclosed subject matter is to be considered illustrative, and not restrictive, and the appended claims are intended to cover all such modifications, enhancements, and other embodiments, which fall within the true spirit and scope of the present invention. Thus, the embodiment of the present invention is to be considered illustrative, and not restrictive, and the technical spirit of the present invention is not limited to the foregoing embodiment. Therefore, the scope of the present invention is defined not by the detailed description of the invention but by the appended claims, and all differences within the scope will be construed as being included in the present invention.

## Claims

1. An electronic device comprising:
a housing provided with a receiving part therein and comprising a polymer resin;
a printed circuit board disposed in the receiving part;
a connector connected to the printed circuit board; and
a shielding member disposed in the receiving part and configured to at least a portion of the printed circuit board,
wherein the shielding member comprises a first region and a second region disposed to have a height difference in a vertical direction with respect to the first region, and
wherein the connector comprises a ground pin that is in contact with the second region.

2. The electronic device according to claim 1, wherein the shielding member is made of a metal material and is integrated with the housing by insert injection.

3. The electronic device according to claim 1, wherein at least a portion of the second region is disposed to overlap the connector and the printed circuit board in the vertical direction.

4. The electronic device according to claim 1, wherein the receiving part comprises a support protruding from a bottom surface, and
the shielding member comprises a third region disposed to have a height difference in the vertical direction with respect to the first region,
wherein the third region is disposed on the support.

5. The electronic device according to claim 4, wherein the printed circuit board is disposed on the support, and
the printed circuit board, the third region, and the support are screw-coupled to each other.

6. The electronic device according to claim 5, further comprising a ground member disposed in the housing and having one end disposed inside the support so as to be screw-coupled to the printed circuit board, the third region, and the support.

7. The electronic device according to claim 6, wherein the housing comprises a coupling part protruding from an outer surface and having a first screw hole, and
the ground member has other end in which a second screw hole facing the first screw hole is defined.

8. The electronic device according to claim 6, wherein the ground member is integrated with the housing by insert injection.

9. The electronic device according to claim 6, wherein the printed circuit board, the third region, the support, and the ground member are disposed to overlap each other in the vertical direction.

10. The electronic device according to claim 1, wherein the shielding member comprises a side surface portion extending from an edge of the first region,
wherein the side surface portion is disposed to face an inner surface of the housing.
